# EUROPEAN PATENT APPLICATION

(11) **EP 4 797 900 A1**
(43) Date of publication of application: **26.08.2026**
(21) Application number: 24890035.9
(22) Date of filing: 27.05.2024
(51) Int. Cl.: H10B 53/30, G11C 11/22, H01L 23/64, H10B 53/40

(54) **FERROELECTRIC MEMORY ARRAY, MANUFACTURING METHOD THEREFOR, MEMORY, AND ELECTRONIC DEVICE**

(30) Priority: 13.11.2023 CN 202311515181
(71) Applicant: HUAWEI TECHNOLOGIES CO., LTD., Shenzhen 518129 (CN)
(72) Inventor: TAN, Wanliang, Shenzhen, Guangdong 518129 (CN); LI, Yuxing, Shenzhen, Guangdong 518129 (CN); CAI, Jialin, Shenzhen, Guangdong 518129 (CN); ZENG, Sheng, Shenzhen, Guangdong 518129 (CN); TIAN, Huanhuan, Shenzhen, Guangdong 518129 (CN); XU, Jeffrey Junhao, Shenzhen, Guangdong 518129 (CN)
(74) Representative: Goddar, Heinz J.
(86) International application number: PCT/CN2024/095617
(87) International publication number: WO 2025/102665

(57) **Abstract**

This application provides a ferroelectric memory array and a preparation method therefor, a memory, and an electronic device, and relates to the field of semiconductor technologies, to increase a data read/write window of the memory and reduce power consumption of the memory. The ferroelectric memory array includes a plurality of memory cells, each memory cell includes a ferroelectric capacitor and a transistor, and the ferroelectric capacitor includes a first electrode and a second electrode that are disposed opposite to each other, and a ferroelectric layer and an intercalation layer that are located between the first electrode and the second electrode. The intercalation layer may be disposed between the ferroelectric layer and the first electrode, or the intercalation layer may be disposed between the ferroelectric layer and the second electrode. Alternatively, intercalation layers are disposed between the ferroelectric layer and the first electrode and between the ferroelectric layer and the second electrode. The intercalation layer includes electric dipoles, and the electric dipoles are distributed on two opposite surfaces of the intercalation layer in a direction from the first electrode to the second electrode. The ferroelectric memory array may be applied to a ferroelectric random access memory, to implement data reading and writing.

## Description

This application claims priority to Chinese Patent Application No. 202311515181.7, filed with the China National Intellectual Property Administration on November 13, 2023 and entitled "FERROELECTRIC MEMORY ARRAY AND PREPARATION METHOD THEREFOR, MEMORY, AND ELECTRONIC DEVICE", which is incorporated herein by reference in its entirety.

### TECHNICAL FIELD

This application relates to the field of semiconductor technologies, and in particular, to a ferroelectric memory array and a preparation method therefor, a memory, and an electronic device.

### BACKGROUND

As a new type of memory, a ferroelectric random access memory (Ferroelectric Random Access Memory, FeRAM) has attracted wide attention due to features such as non-volatile storage of data, a high access rate, a low read/write voltage, and low power consumption.

Generally, the ferroelectric random access memory includes a ferroelectric capacitor. The ferroelectric capacitor includes two electrodes disposed opposite to each other and a ferroelectric layer disposed between the two electrodes. Currently, a mainstream material of the ferroelectric layer includes a hafnium oxide-based ferroelectric material, which still has ferroelectric properties at a small thickness.

Based on the foregoing architecture, how to increase a data read/write window of a memory and reduce power consumption of the memory becomes an urgent problem to be resolved in the field.

### SUMMARY

Embodiments of this application provide a ferroelectric memory array and a preparation method therefor, a memory, and an electronic device, to increase a data read/write window of the memory and reduce power consumption of the memory.

To achieve the foregoing objectives, the following technical solutions are used in embodiments of this application.

According to a first aspect, a ferroelectric memory array is provided. The ferroelectric memory array may be of a two-dimensional structure or a three-dimensional structure. In addition, the ferroelectric memory array may be used in a ferroelectric random access memory, a ferroelectric field effect transistor memory, or a ferroelectric tunnel junction memory, to implement data reading and writing.

The ferroelectric memory array includes a plurality of memory cells arranged in an array, each memory cell includes a ferroelectric capacitor and a transistor, and the ferroelectric capacitor includes a first electrode and a second electrode that are disposed opposite to each other, and a ferroelectric layer and an intercalation layer that are located between the first electrode and the second electrode. The intercalation layer may be disposed between the ferroelectric layer and the first electrode, or the intercalation layer may be disposed between the ferroelectric layer and the second electrode. Alternatively, intercalation layers are disposed between the ferroelectric layer and the first electrode and between the ferroelectric layer and the second electrode. When the first electrode and the second electrode do not receive a voltage signal, the intercalation layer includes electric dipoles, that is, when no external electric field is applied to the intercalation layer, the electric dipoles may be generated based on a material characteristic of the intercalation layer, and the electric dipoles are distributed on two opposite surfaces of the intercalation layer in a direction from the first electrode to the second electrode.

In the foregoing embodiment of this application, the intercalation layer is disposed between the ferroelectric layer and the electrode (the first electrode or the second electrode), the electric dipoles are distributed on the two opposite surfaces of the intercalation layer in the direction from the first electrode to the second electrode, and the electric dipoles can generate an electric field. In a process of preparing the ferroelectric layer, a polarization axis of a ferroelectric material of the ferroelectric layer is arranged in an electric field direction of the electric dipoles under guidance of the electric field generated by the electric dipoles, to help improve a spontaneous polarization characteristic of the ferroelectric material.

In addition, when an external electric field generated by the first electrode and the second electrode is reversed, charge migration may occur on the electric dipoles at the intercalation layer in response to reversal of the external electric field, to increase an amount of polarized charges. A total amount of polarization-induced currents is equal to an induced current generated by polarization of the ferroelectric material and an induced current of the electric dipoles. This increases a remnant polarization of the ferroelectric material, better distinguishes between positive and negative polarization states, and increases a data read/write window of a memory mounted with the ferroelectric capacitor.

In addition, ferroelectric switching occurs on the ferroelectric material under an action of the reversed external electric field, and the electric field generated by the electric dipoles may be used as a "depolarization electric field" to assist in ferroelectric switching, to improve efficiency of ferroelectric switching, reduce a coercive field of the ferroelectric material. The external electric field required for ferroelectric switching is reduced, to reduce an operating voltage of the ferroelectric capacitor, and help reduce power consumption of the memory.

In some embodiments, the intercalation layer includes at least one first intercalation sublayer and at least one second intercalation sublayer, and the first intercalation sublayer and the second intercalation sublayer are alternately disposed in the direction from the first electrode to the second electrode. A dielectric constant of a material of the first intercalation sublayer is different from a dielectric constant of a material of the second intercalation sublayer, a dielectric constant of a material on a surface on which the first intercalation sublayer is in contact with the second intercalation sublayer changes, and the first intercalation sublayer and the second intercalation sublayer are stacked in a superlattice manner, so that two opposite surfaces of the first intercalation sublayer generate electric dipoles, and two opposite surfaces of the second intercalation sublayer generate electric dipoles.

In some embodiments, the intercalation layer is doped with an element, and the doped element includes at least one of niobium, titanium, hafnium, zirconium, lanthanum, yttrium, strontium, silicon, germanium, tantalum, or tungsten. The intercalation layer is doped with the element, to change intrinsic parameters of the material of the intercalation layer. Therefore, a defect with a high concentration and a low energy level is introduced into the material, to generate electric dipoles at the intercalation layer.

In some embodiments, the material of the intercalation layer includes a piezoelectric material. According to piezoelectric effect, when the intercalation layer is under pressure, electric dipoles are generated on the two opposite surfaces of the intercalation layer.

In some embodiments, the material of the intercalation layer includes a pyroelectric material, and the pyroelectric material is also a type of piezoelectric material. The pyroelectric material can generate electric dipoles when being heated or pressed.

In some embodiments, the material of the intercalation layer includes a ferroelectric material, and the ferroelectric material is a type of a pyroelectric material. Therefore, the ferroelectric material can also generate electric dipoles when being heated or pressed. In addition, during a process of depositing the ferroelectric material to form the intercalation layer, the intercalation layer can also generate electric dipoles.

In addition, the piezoelectric material, the pyroelectric material, or the ferroelectric material has negative capacitance effect, and these materials are all negative capacitance materials. According to the negative capacitance effect, when the first electrode and the second electrode receive the voltage signal and generate the external electric field, electrons at the intercalation layer migrate to the surface of the intercalation layer under the action of the external electric field. Negative charges are distributed on the surface, and positive charges are distributed on the other surface opposite to the surface, so that the electric dipoles are generated on the two opposite surfaces of the intercalation layer.

In some embodiments, the material of the intercalation layer may include at least one of a piezoelectric material, a pyroelectric material, a ferroelectric material, or a negative capacitance material. The intercalation layer may generate the electric dipoles based on a respective material characteristic of the intercalation layer to which no external electric field is applied.

In some embodiments, the material of the intercalation layer includes at least one of titanium oxide, niobium oxide, tantalum oxide, yttrium oxide, lanthanum oxide, barium oxide, cerium oxide, gadolinium oxide, aluminum oxide, hafnium oxide, zirconium oxide, silicon nitride, titanium nitride, niobium nitride, tantalum nitride, hafnium nitride, zirconium nitride, strontium titanate, barium titanate, lanthanum aluminate, lithium niobate, or lithium tantalate.

In some embodiments, a thickness of the intercalation layer ranges from 0.5 nm to 5 nm. Compared with a thickness of the ferroelectric layer, the thickness of the intercalation layer is thin, to reduce voltage division effect of the intercalation layer, and prevent an operating voltage of the ferroelectric capacitor from being excessively high due to disposing of the intercalation layer.

In some embodiments, both the first electrode and the second electrode are planar electrodes, and the first electrode, the ferroelectric layer, the intercalation layer, and the second electrode are stacked. The ferroelectric capacitor is of a two-dimensional planar structure, and the structure is simple and is easy to prepare.

In some embodiments, the first electrode is a planar electrode, and the second electrode is a columnar electrode. The second electrode penetrates the first electrode, and both the ferroelectric layer and the intercalation layer are disposed around the second electrode. The ferroelectric capacitor is of a three-dimensional vertical structure, to reduce an area occupied by the ferroelectric capacitor on a plane. This can increase a quantity of ferroelectric capacitors disposed per unit area on the plane, to increase a quantity of memory cells disposed per unit area, and help improve storage density of the ferroelectric memory.

In some embodiments, a thermal expansion coefficient of a material of the first electrode is different from a thermal expansion coefficient of a material of the second electrode. In a process of annealing and crystallization of the ferroelectric layer, the first electrode and the second electrode expand at a high temperature. Because the thermal expansion coefficients of the materials of the first electrode and the second electrode are different, deformations of the first electrode and the second electrode are different, to generate an interaction force. When the intercalation layer is made of the piezoelectric material, the interaction force is applied to the intercalation layer, so that the intercalation layer generates the electric dipoles.

According to a second aspect, a method for preparing a ferroelectric memory array is provided. The preparation method includes: sequentially forming a first electrode, a ferroelectric layer, and a second electrode, where the first electrode and the second electrode are disposed opposite to each other, and the ferroelectric layer is located between the first electrode and the second electrode. After the first electrode is formed and before the ferroelectric layer is formed, an intercalation layer is further formed; and/or after the ferroelectric layer is formed and before the second electrode is formed, the intercalation layer is further formed. The intercalation layer includes electric dipoles, and the electric dipoles are distributed on two opposite surfaces of the intercalation layer in a direction from the first electrode to the second electrode.

According to the preparation method provided in the foregoing embodiments of this application, the first electrode, the ferroelectric layer, and the second electrode are sequentially formed, and the intercalation layer is formed between the first electrode and the ferroelectric layer, and the intercalation layer is formed between the ferroelectric layer and the second electrode. The electric dipoles are distributed on the two opposite surfaces of the intercalation layer in the direction from the first electrode to the second electrode, and the electric dipoles can generate an electric field.

In a process of forming the ferroelectric layer, a polarization axis of a ferroelectric material of the ferroelectric layer is arranged in an electric field direction of the electric dipoles under guidance of the electric field generated by the electric dipoles, to help improve a spontaneous polarization characteristic of the ferroelectric material.

According to a third aspect, a memory is provided. The memory includes the ferroelectric memory array in any one of the foregoing embodiments, and a controller electrically connected to the ferroelectric memory array.

According to a fourth aspect, an electronic device is provided. The electronic device is, for example, a consumer electronic product, a home electronic product, a vehicle-mounted electronic product, a financial terminal product, or a communication electronic product. The electronic device includes a circuit board and the memory in the foregoing embodiments, and the memory is electrically connected to the circuit board.

It may be understood that, for beneficial effect that can be achieved by the memory and the electronic device provided in the foregoing embodiments of this application, refer to beneficial effect of the foregoing ferroelectric memory array. Details are not described herein again.

### BRIEF DESCRIPTION OF DRAWINGS

To describe technical solutions in this application more clearly, the following briefly describes accompanying drawings used for describing some embodiments of this application. It is clear that the accompanying drawings in the following descriptions are merely accompanying drawings in some embodiments of this application. A person of ordinary skill in the art may further derive other drawings from these accompanying drawings. In addition, the accompanying drawings in the following descriptions may be considered as diagrams, and are not intended to limit an actual size of a product, an actual procedure of a method, an actual timing of a signal, and the like in embodiments of this application.
FIG. 1 is a diagram of an architecture of an electronic device according to an embodiment of this application;
FIG. 2 is an exploded diagram of an electronic device according to an embodiment of this application;
FIG. 3 is a diagram of an architecture of a ferroelectric random access memory according to an embodiment of this application;
FIG. 4 is a diagram of a circuit of a memory cell according to an embodiment of this application;
FIG. 5 is a diagram of a structure of a ferroelectric capacitor in a related technology;
FIG. 6 to FIG. 8 are diagrams of structures of a plurality of ferroelectric capacitors according to an embodiment of this application;
FIG. 9 and FIG. 10 are diagrams of ferroelectric hysteresis loops of ferroelectric capacitors according to an embodiment of this application;
FIG. 11 and FIG. 12 are diagrams of structures of a plurality of ferroelectric capacitors according to an embodiment of this application;
FIG. 13A to FIG. 13E are diagrams of steps of preparing a ferroelectric capacitor according to an embodiment of this application;
FIG. 14A to FIG. 14E are diagrams of steps of preparing a ferroelectric capacitor according to an embodiment of this application;
FIG. 15 is a diagram of a three-dimensional structure of a ferroelectric capacitor according to an embodiment of this application; and
FIG. 16A to FIG. 16G are diagrams of steps of preparing a ferroelectric capacitor according to an embodiment of this application.

### DESCRIPTION OF EMBODIMENTS

The following clearly and completely describes technical solutions in some embodiments of this application with reference to accompanying drawings. It is clear that the described embodiments are merely some rather than all embodiments of this application. All other embodiments obtained by a person of ordinary skill in the art based on embodiments of this application shall fall within the protection scope of this application.

Some embodiments of this application provide an electronic device. The electronic device may be different types of user equipments or terminal devices such as a mobile phone, a tablet computer, a personal digital assistant (Personal Digital Assistant, PDA), a television, or an intelligent wearable product (for example, a smartwatch or a smart band), a virtual reality (Virtual Reality, VR) terminal device, an augmented reality (Augmented Reality, AR) terminal device, a small-sized charging household appliance (for example, a soy milk maker or a robotic vacuum cleaner), an uncrewed aerial vehicle, a radar, an aerospace device, and a vehicle-mounted device. The electronic device may alternatively be a network device like a base station. The specific form of the electronic device is not specifically limited in embodiments of this application.

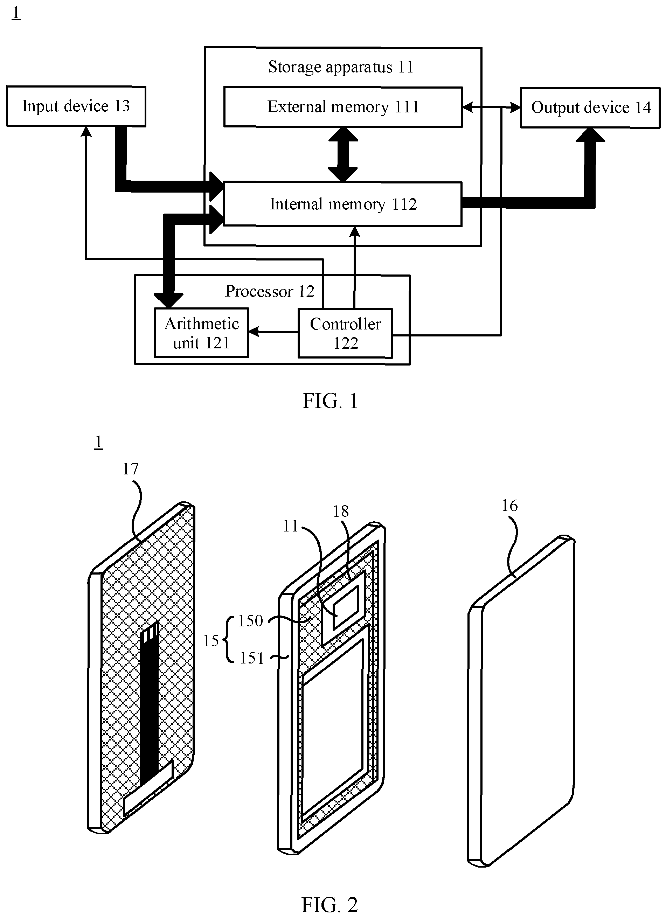

FIG. 1 is a diagram of an architecture of an electronic device according to an embodiment of this application.

Refer to FIG. 1. An electronic device 1 includes components such as a storage apparatus 11, a processor 12, an input device 13, and an output device 14. A person skilled in the art may understand that the architecture of the electronic device 1 shown in FIG. 1 does not constitute a limitation on the electronic device 1. The electronic device 1 may include more or fewer components than those shown in FIG. 1, or may combine some of the components shown in FIG. 1. Alternatively, component arrangement may be different from that shown in FIG. 1.

The storage apparatus 11 is configured to store a software program and a module. The storage apparatus 11 mainly includes a program storage region and a data storage region. The program storage region may store and back up an operating system, an application program and the like required by at least one function (for example, a sound play function or an image play function). The data storage region may store data (for example, audio data, image data, and a phone book) and the like created based on usage of the electronic device 1. In addition, the storage apparatus 11 includes an external memory 111 and an internal memory 112. Data stored in the external memory 111 and the internal memory 112 may be transmitted to each other.

The external memory 111 may include, for example, a hard disk, a USB flash drive, and a floppy disk. The internal memory 112 may include, for example, a dynamic random access memory (Dynamic Random Access Memory, DRAM), a static random access memory (Static Random Access Memory, SRAM), a resistive random access memory (Resistive Random Access Memory, RRAM), a phase change memory (Phase Change Random Access Memory, PCRAM), a ferroelectric random access memory (Ferroelectric Random Access Memory, FeRAM), a ferroelectric field effect transistor (Ferroelectric Field-Effect-Transistor, FeFET) memory, a ferroelectric tunnel junction (Ferroelectric Tunnel Junction, FTJ) memory, and a NAND flash (NAND Flash).

The processor 12 is a control center of the electronic device 1, is connected to all parts of the entire electronic device 1 through various interfaces and lines, and performs various functions and data processing of the electronic device 1 by running or executing the software program and/or the module stored in the storage apparatus 11 and invoking data stored in the storage apparatus 11. In this way, overall monitoring is performed on the electronic device 1. Optionally, the processor 12 may include one or more processing units. For example, the processor 12 may include an application processor (Application Processor, AP), a modem processor, and a graphics processing unit (Graphics Processing Unit, GPU). Different processing units may be independent components, or may be integrated into one or more processors. For example, the processor 12 may integrate the application processor and the modem processor. The application processor mainly processes an operating system, a user interface, an application, and the like. The modem processor mainly processes wireless communication. It may be understood that the modem processor may not be integrated into the processor 12. The application processor may be, for example, a central processing unit (Central Processing Unit, CPU). In FIG. 1, an example in which the processor 12 is a CPU is used. The CPU may include an arithmetic unit 121 and a controller 122. The arithmetic unit 121 obtains data stored in the internal memory 112, processes the data stored in the internal memory 112, and usually sends a processing result back to the internal memory 112. The controller 122 may control the arithmetic unit 121 to process the data, and the controller 122 may further control the external memory 111 and the internal memory 112 to read or write the data.

The input device 13 is configured to receive input digit or character information, and generate key signal input related to user setting and function control of the electronic device. For example, the input device 13 may include a touchscreen and another input device. The touchscreen, also referred to as a touch panel, may collect a touch operation performed by a user on the touchscreen or near the touchscreen (for example, an operation performed by the user on the touchscreen or near the touchscreen by using any suitable object or accessory such as a finger or a stylus), and drive a corresponding connection apparatus based on a preset program. The controller 122 in the processor 12 may further control the input device 13 to receive an input signal or not to receive an input signal. In addition, the input digit or character information received by the input device 13 and the key signal input related to the user setting and function control of the electronic device may be stored in the internal memory 112.

The output device 14 is configured to output a signal corresponding to data that is input by the input device 13 and stored in the internal memory 112. For example, the output device 14 outputs a sound signal or a video signal. The controller 122 in the processor 12 may further control the output device 14 to output a signal or not to output a signal.

It should be noted that a bold arrow in FIG. 1 indicates data transmission, and a direction of the bold arrow indicates a data transmission direction. For example, a unidirectional arrow between the input device 13 and the internal memory 112 indicates that data received by the input device 13 is transmitted to the internal memory 112. For another example, a bidirectional arrow between the arithmetic unit 121 and the internal memory 112 indicates that the data stored in the internal memory 112 may be transmitted to the arithmetic unit 121, and data processed by the arithmetic unit 121 may be transmitted to the internal memory 112. A thin arrow in FIG. 1 indicates a component that can be controlled by the controller 122. For example, the controller 122 may control the external memory 111, the internal memory 112, the arithmetic unit 121, the input device 13, and the output device 14.

For ease of further describing a structure of the electronic device 1, the following uses an example in which the electronic device 1 is a mobile phone for description.

FIG. 2 is an exploded diagram of an electronic device according to an embodiment of this application.

Refer to FIG. 2. The electronic device 1 may further include a middle frame 15, a rear housing 16, and a display 17. The rear housing 16 and the display 17 are respectively located on two opposite sides of the middle frame 15, and the middle frame 15 and the display 17 are disposed in the rear housing 16. The middle frame 15 includes a bearing plate 150 configured to bear the display 17, and a frame 151 that surrounds the bearing plate 150.

Still refer to FIG. 2. The electronic device 1 may further include a circuit board 18. The circuit board 18 is disposed on a side that is of the bearing plate 150 and that is close to the rear housing 16. The storage apparatus 11 in the electronic device 1 may be disposed on the circuit board 18, and a memory in the storage apparatus 11 is electrically connected to the circuit board 18.

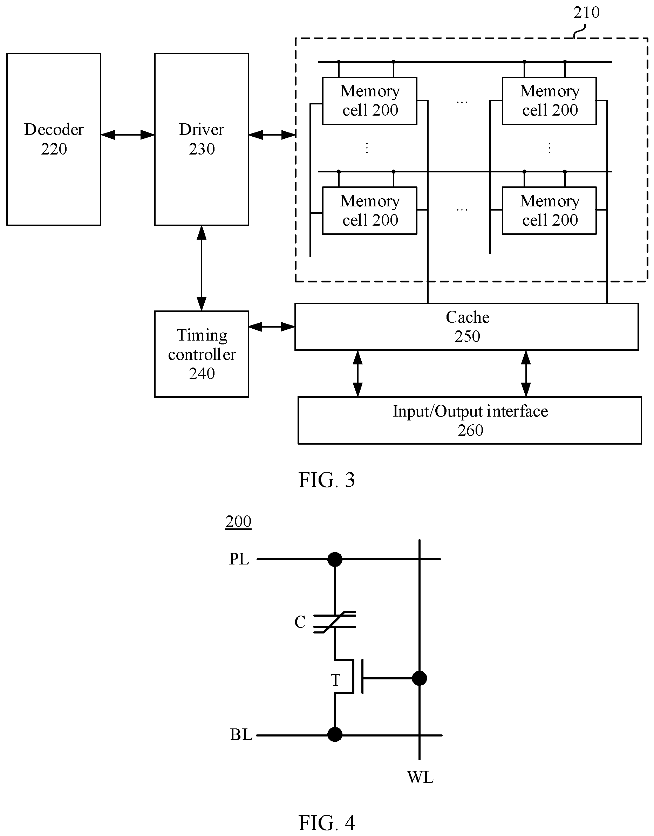

The following embodiments are described by using an example in which the memory is a ferroelectric random access memory. FIG. 3 is a diagram of an architecture of a ferroelectric random access memory according to an embodiment of this application.

Refer to FIG. 3. The ferroelectric random access memory includes a ferroelectric memory array 210, a decoder 220, a driver 230, a timing controller 240, a cache 250, and an input/output interface 260. The ferroelectric memory array 210 includes a plurality of memory cells 200 arranged in an array.

FIG. 4 is a diagram of a circuit of a memory cell according to an embodiment of this application.

Refer to FIG. 4. A memory cell 200 includes a circuit architecture based on a ferroelectric capacitor. The memory cell 200 has a 1T1C (1-transistor-1-capacitor) structure, that is, the memory cell 200 includes one transistor T and one ferroelectric capacitor C. A source of the transistor T is electrically connected to a bit line (Bit Line, BL). A drain is electrically connected to one electrode of the ferroelectric capacitor C. A gate is electrically connected to a word line (Word Line, WL). The other electrode of the ferroelectric capacitor C is electrically connected to a plate line (Plate Line, PL). A circuit architecture of the memory cell 200 in embodiments of this application is not limited thereto.

In view of this, the decoder 220 may perform decoding based on a received address, to determine the memory cell 200 that needs to be accessed in the ferroelectric memory array 210. The driver 230 is configured to generate a control signal based on a decoding result output by the decoder 220. The control signal is transmitted to the gate of the transistor T in the memory cell 200 through the word line WL, to control the transistor T to be conducted or cut off, to access the specified memory cell 200. The cache 250 receives a data signal output by the memory cell 200, and is configured to cache the data signal. For example, the data signal may be cached through first-in first-out (First-In First-Out, FIFO). The timing controller 240 is configured to control a timing of the cache 250, and control the drive 230 to drive the ferroelectric memory array 210. The input/output interface 260 is configured to transmit a data signal, for example, receive the data signal or send the data signal.

The ferroelectric memory array 210, the decoder 220, the driver 230, the timing controller 240, the cache 250, and the input/output interface 260 may be integrated into one chip, or may be respectively integrated into a plurality of chips.

The following describes a working principle of the ferroelectric random access memory based on a structure of the ferroelectric capacitor.

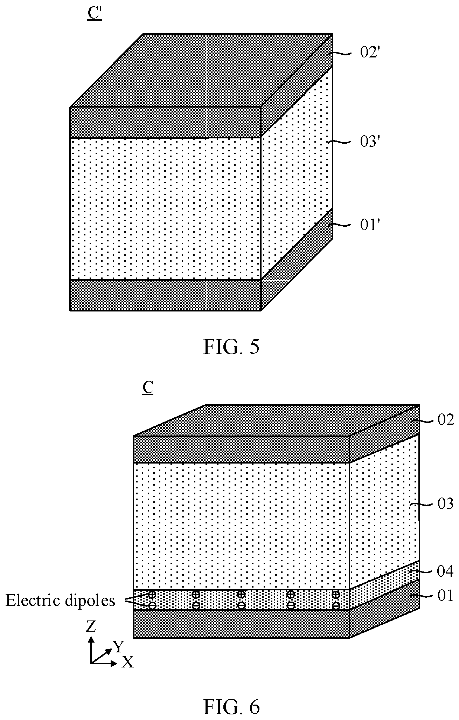

FIG. 5 is a diagram of a structure of a ferroelectric capacitor in a related technology.

Refer to FIG. 5. The ferroelectric capacitor C' includes a first electrode 01' and a second electrode 02' that are disposed opposite to each other, and a ferroelectric film 03' disposed between the first electrode 01' and the second electrode 02'. The ferroelectric capacitor C' has a metal-insulator-metal (Metal-Insulator-Metal) MIM structure. The ferroelectric film 03' includes a ferroelectric material, and the ferroelectric material has a spontaneous polarization characteristic.

Specifically, the ferroelectric material includes a ferroelectric phase crystal. When the first electrode 01' and the second electrode 02' receive a voltage signal and generate an external electric field, the external electric field is applied to the ferroelectric film 03'. Central atoms in a unit cell of an orthogonal phase in the ferroelectric material move along the external electric field and settle in a low energy state, and the polarization state may be, for example, a "0" storage state. A large quantity of central atoms move and are coupled in the unit cell to form a ferroelectric domain, and the ferroelectric domain forms a polarized charge under an action of the external electric field.

The ferroelectric material has a coercive field (Coercive field, Ec). When the external electric field generated by the first electrode 01' and the second electrode 02' is reversed and is greater than the coercive field, the central atoms move in the unit cell in a direction of the external electric field and settle in another low energy state, and the polarization state may be, for example, a "1" storage state, that is, the ferroelectric domain is directionally switched under the action of the reversed external electric field.

Energy of polarized charges formed by the ferroelectric domain before and after the external electric field is reversed is different. The positive/negative polarization state enables the ferroelectric capacitor C' to charge/discharge, to generate a current. Further, the current can be identified by an external sense amplifier, to determine whether the memory cell 200 is in the "0" or "1" storage state. Therefore, the ferroelectric random access memory can implement data reading and writing.

In addition, when the external electric field is removed, the polarization state of the ferroelectric material can be maintained, so that the ferroelectric random access memory has non-volatility for data storage.

However, after the ferroelectric domain is directionally switched for a plurality of times, polarization strength decreases. Specifically, during data reading/writing, the ferroelectric random access memory performs a plurality of programming/erasing operations, and the ferroelectric domain at the ferroelectric layer 03' are constantly switched. After a plurality of times of switching, a remnant polarization (Remnant Polarization, Pr) of the ferroelectric domain at the ferroelectric layer 03' decreases, and a coercive field increases. A smaller remnant polarization indicates fewer polarized charges. Consequently, the two states "0" and "1" are closer to each other, making it hard to distinguish between the positive and negative polarization states of the ferroelectric layer 03', and the two states even cannot be distinguished. This increases an error rate of reading/writing data by the ferroelectric random access memory mounted with the ferroelectric capacitor C'. In addition, a larger coercive field indicates a larger external electric field for reversal and a larger operating voltage of the ferroelectric capacitor C', resulting in larger power consumption, a shorter read/write life, and a poorer anti-interference capability of the memory.

To resolve the foregoing problems, an embodiment of this application provides a ferroelectric capacitor. FIG. 6 to FIG. 8 are diagrams of structures of a plurality of ferroelectric capacitors according to an embodiment of this application.

Refer to FIG. 6. A ferroelectric capacitor C includes a first electrode 01 and a second electrode 02 that are disposed opposite to each other, and a ferroelectric layer 03 and an intercalation layer 04 that are located between the first electrode 01 and the second electrode 02.

The ferroelectric capacitor C may have a two-dimensional planar structure, and both the first electrode 01 and the second electrode 02 are planar electrodes, and the two planar electrodes are disposed opposite to each other. The first electrode 01, the ferroelectric layer 03, the intercalation layer 04, and the second electrode 02 are stacked, and a structure of the ferroelectric capacitor C is simple and easy to prepare.

For example, materials of the first electrode 01 and the second electrode 02 each may include at least one of titanium nitride, tantalum nitride, and tungsten.

For example, a material of the ferroelectric layer 03 includes a hafnium oxide-based fluorite material, and the hafnium oxide-based fluorite material may include hafnium zirconium oxide (Hafnium Zirconium Oxide, HZO for short), hafnium silicon oxide, hafnium aluminum oxide, hafnium lanthanum oxide, hafnium zirconium lanthanum oxide, hafnium zirconium cerium oxide, hafnium yttrium oxide, hafnium zirconium gadolinium oxide, and the like. Compared with a conventional ferroelectric material, the hafnium oxide-based material has a stable ferroelectric switching property, and can improve charging/discharging performance of the ferroelectric capacitor C.

In addition, a preparation process of the ferroelectric layer 03 made of the hafnium oxide-based fluorite material is well compatible with a preparation process of a complementary metal-oxide-semiconductor (Complementary Metal-Oxide-Semiconductor, CMOS for short), so that a thickness of the ferroelectric layer 03 can be reduced to 10 nanometers or even less than 10 nanometers, and a spontaneous polarization characteristic of the ferroelectric layer 03 can be maintained. This facilitates size miniaturization of the ferroelectric capacitor C.

Refer to FIG. 6. The intercalation layer 04 may be disposed between the ferroelectric layer 03 and the first electrode 01, which is equivalent to inserting the intercalation layer 04 between the ferroelectric layer 03 and the first electrode 01. A quantity of inserted intercalation layers 04 is not limited, and there may be one or more intercalation layers 04.

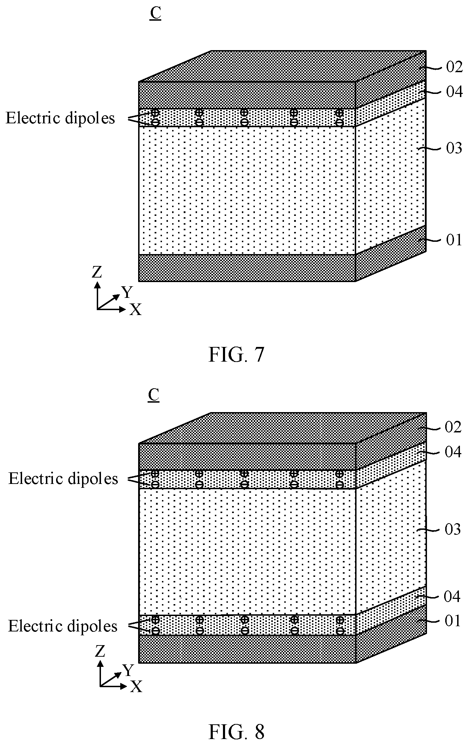

Refer to FIG. 7. The intercalation layer 04 may alternatively be disposed between the ferroelectric layer 03 and the second electrode 02, which is equivalent to inserting the intercalation layer 04 between the ferroelectric layer 03 and the second electrode 02. A quantity of inserted intercalation layers 04 is not limited, and there may be one or more intercalation layers 04.

Refer to FIG. 8. The intercalation layers 04 may be disposed between the ferroelectric layer 03 and the first electrode 01 and between the ferroelectric layer 03 and the second electrode 02. This is equivalent to inserting the intercalation layer 04 between the ferroelectric layer 03 and the first electrode 01, and inserting the intercalation layer 04 between the ferroelectric layer 03 and the second electrode 02.

When the first electrode 01 and the second electrode 02 do not receive the voltage signal, the intercalation layer 04 includes electric dipoles (dipoles), that is, the intercalation layer 04 may generate the electric dipoles (described below based on material selection of the intercalation layer 04) based on a material characteristic of the intercalation layer 04 without an external electric field. The electric dipoles are a system including two point charges with equal magnitude and opposite signs. For example, in the direction from the first electrode 01 to the second electrode 02, that is, in a direction Z, the intercalation layer 04 includes two opposite surfaces, and a positive point charge and a negative point charge are respectively distributed near the two surfaces of the intercalation layer 04. An electric field may be generated between the positive point charge and the negative point charge, and a direction of the electric field may be the direction Z. Therefore, there is a potential difference between two opposite ends of the intercalation layer 04 in the direction Z.

Refer to FIG. 8. For example, when the intercalation layers 04 are disposed between the ferroelectric layer 03 and the first electrode 01 and between the ferroelectric layer 03 and the second electrode 02, a positive point charge at the upper intercalation layer 04 and a negative point charge at the lower intercalation layer 04 may be combined to form a "long-range" electric dipole. Similarly, a negative point charge at the upper intercalation layer 04 and a positive point charge at the lower intercalation layer 04 may alternatively be combined to form a "long-range" electric dipole. The "long-range" electric dipole can generate an electric field. Therefore, there is also a potential difference between the upper intercalation layer 04 and the lower intercalation layer 04.

According to the ferroelectric capacitor C provided in the foregoing embodiments of this application, the intercalation layer 04 is inserted between the ferroelectric layer 03 and the electrode (the first electrode 01 or the second electrode 02), and the intercalation layer 04 may form the electric dipoles on an interface of the intercalation layer 04. The electric dipoles may generate the electric field. In a process step (crystallization) of preparing the ferroelectric layer 03, a polarization axis of the ferroelectric material is arranged in an electric field direction of the electric dipoles under guidance of the electric field generated by the electric dipoles, to help improve the spontaneous polarization characteristic of the ferroelectric material.

In addition, when an external electric field generated by the first electrode 01 and the second electrode 02 is reversed, charge migration may occur on the electric dipoles at the intercalation layer 04 in response to reversal of the external electric field, to increase an amount of polarized charges. A total amount of polarization-induced currents is equal to an induced current generated by polarization of the ferroelectric material and an induced current of the electric dipoles. This increases a remnant polarization, better distinguishes between positive and negative polarization states of the ferroelectric layer 03, and increases a data read/write window of a ferroelectric random access memory mounted with the ferroelectric capacitor C. This is particularly important for a small-sized device with high-density integration.

In addition, the intercalation layer 04 may generate more electric dipoles in response to the external electric field, directional switching occurs on the ferroelectric domain under an action of the reversed external electric field, and the electric field generated by the electric dipoles may be used as a "depolarization electric field" to assist in switching of the ferroelectric domain, to improve switching efficiency of the ferroelectric domain, reduce a coercive field of the ferroelectric material. The external electric field required for switching of the ferroelectric domain is reduced, to reduce an operating voltage of the ferroelectric capacitor C, and help reduce power consumption of the memory.

To verify the foregoing conclusion, ferroelectric hysteresis loops of a ferroelectric capacitor without an intercalation layer and a ferroelectric capacitor with an intercalation layer may be tested and compared.

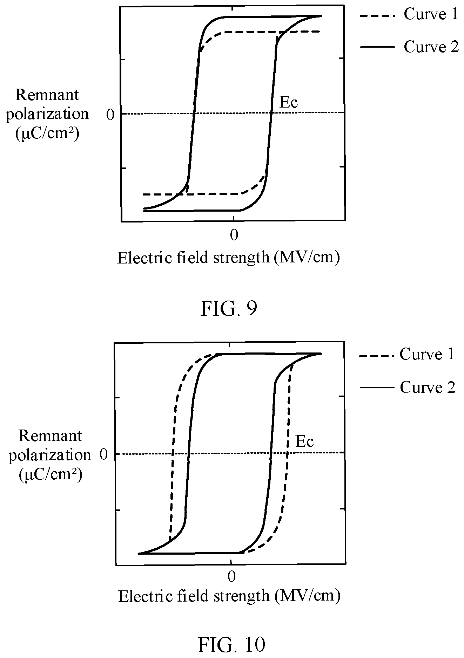

FIG. 9 and FIG. 10 are diagrams of ferroelectric hysteresis loops of ferroelectric capacitors according to an embodiment of this application. A horizontal coordinate is electric field strength generated by the first electrode 01 and the second electrode 02, and a unit is "MV/cm", and a vertical coordinate is a remnant polarization of the ferroelectric layer, and a unit is "µC/cm²". A curve "1" is a ferroelectric hysteresis loop of the ferroelectric capacitor without an intercalation layer, and a curve "2" is a ferroelectric hysteresis loop of the ferroelectric capacitor with an intercalation layer.

Refer to FIG. 9. A maximum value of the remnant polarization corresponding to the curve "2" is greater than a maximum value of the remnant polarization corresponding to the curve "1". It indicates that the positive and negative polarization states of the ferroelectric layer in the ferroelectric capacitor with an intercalation layer can be better distinguished in comparison with the positive and negative polarization states of the ferroelectric layer in the ferroelectric capacitor without an intercalation layer. Therefore, disposing of the intercalation layer can increase the data read/write window.

Refer to FIG. 10. When the remnant polarization is 0, a maximum value of the electric field strength corresponding to the curve "2" is less than a maximum value of the electric field strength corresponding to the curve "2". It indicates that a coercive field Ec of the ferroelectric layer in the ferroelectric capacitor with an intercalation layer is less than a coercive field Ec of the ferroelectric layer in the ferroelectric capacitor without an intercalation layer. Therefore, disposing of the intercalation layer can reduce the coercive field of the ferroelectric layer, and the electric field strength of the external electric field required for ferroelectric switching is reduced.

Then, the following describes a disposing form of the intercalation layer 04 and how to form the electric dipoles.

The intercalation layer 04 may be a single film layer. Still refer to FIG. 6 to FIG. 8. A material of the intercalation layer 04 may include a piezoelectric material. According to piezoelectric effect, when the intercalation layer 04 is under pressure in the direction Z, electric dipoles are generated on the two opposite surfaces of the intercalation layer 04.

Alternatively, the material of the intercalation layer 04 may include a pyroelectric material, and crystals of the pyroelectric material are non-centrosymmetric, so that the pyroelectric material is also a type of piezoelectric material. The pyroelectric material can generate electric dipoles when being heated or pressed.

Alternatively, the material of the intercalation layer 04 may include a ferroelectric material, and the ferroelectric material is a type of a pyroelectric material. Therefore, the ferroelectric material can also generate electric dipoles when being heated or pressed. In addition, during a process of depositing the ferroelectric material to form the intercalation layer 04, the intercalation layer 04 can also generate electric dipoles.

In addition, the piezoelectric material, the pyroelectric material, or the ferroelectric material has negative capacitance effect, and these materials are all negative capacitance materials. According to the negative capacitance effect, when the first electrode 01 and the second electrode 02 receive the voltage signal and generate the external electric field, electrons at the intercalation layer 04 migrate to the surface of the intercalation layer 04 under the action of the external electric field. Negative charges are distributed on the surface, and positive charges are distributed on the other surface opposite to the surface, so that the electric dipoles are generated on the two opposite surfaces of the intercalation layer 04.

In some embodiments, the material of the intercalation layer 04 may include one or more of a piezoelectric material, a pyroelectric material, a ferroelectric material, or a negative capacitance material. The intercalation layer 04 may generate the electric dipoles based on a respective material characteristic of the intercalation layer 04 to which no external electric field is applied.

In some embodiments, a thermal expansion coefficient of a material of the first electrode 01 is different from a thermal expansion coefficient of a material of the second electrode 02. In a process of annealing and crystallization of the ferroelectric layer 03, the first electrode 01 and the second electrode 02 expand at a high temperature. Because the thermal expansion coefficients of the materials of the first electrode 01 and the second electrode 02 are different, deformations of the first electrode 01 and the second electrode 02 are different, to generate an interaction force in the direction Z. The interaction force may be applied to the intercalation layer 04, so that the intercalation layer 04 generates the electric dipoles.

For example, a material of one of the first electrode 01 and the second electrode 02 includes titanium nitride, and a material of the other includes tungsten. Titanium nitride and tungsten have different thermal expansion coefficients.

Alternatively, in some embodiments, the material of the intercalation layer 04 mainly includes a piezoelectric material, a pyroelectric material, or a ferroelectric material. In this case, the intercalation layer 04 is also doped with an element, and the doped element includes at least one of niobium, titanium, hafnium, zirconium, lanthanum, yttrium, strontium, silicon, germanium, tantalum, or tungsten. The intercalation layer 04 is doped with the element, to change intrinsic parameters of the material of the intercalation layer 04. Therefore, a defect with a high concentration and a low energy level is introduced into the material, to generate electric dipoles at the intercalation layer 04. Therefore, a potential difference is generated between the two opposite ends of the intercalation layer 04.

For example, the material of the intercalation layer 04 may mainly include one or more of titanium oxide, niobium oxide, tantalum oxide, yttrium oxide, lanthanum oxide, barium oxide, cerium oxide, gadolinium oxide, aluminum oxide, hafnium oxide, zirconium oxide, silicon nitride, titanium nitride, niobium nitride, tantalum nitride, hafnium nitride, zirconium nitride, strontium titanate, barium titanate, lanthanum aluminate, lithium niobate, or lithium tantalate.

For example, a thickness of the intercalation layer 04 may range from 0.5 nm to 5 nm. For example, the thickness of the intercalation layer 04 is 0.5 nm, 1 nm, 2 nm, 2.5 nm, 3 nm, 4 nm, or 5 nm. Compared with a thickness of the ferroelectric layer 03, the thickness of the intercalation layer 04 is thin, to reduce voltage division effect of the intercalation layer 04, and prevent an operating voltage of the ferroelectric capacitor C from being excessively high due to disposing of the intercalation layer 04.

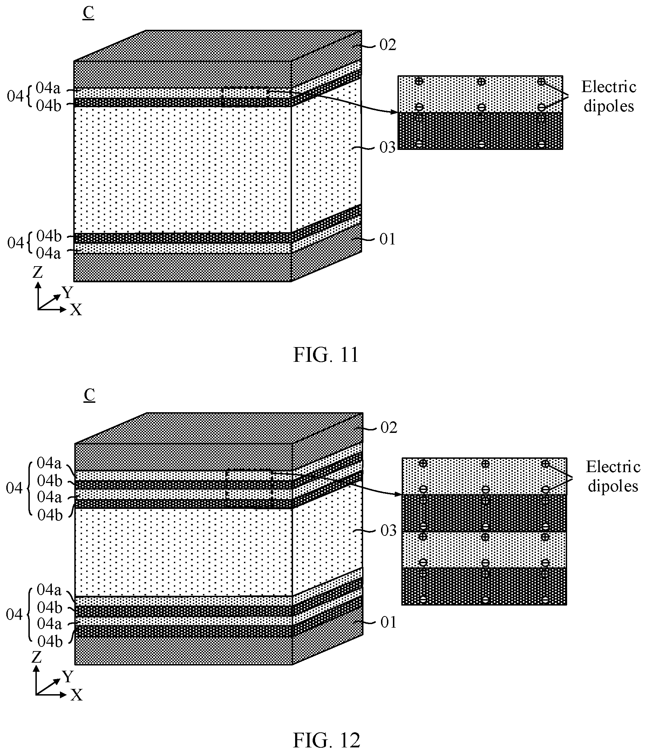

The intercalation layer 04 may alternatively be a composite film layer. FIG. 11 and FIG. 12 are diagrams of structures of a plurality of ferroelectric capacitors according to an embodiment of this application.

Refer to FIG. 11 and FIG. 12. The intercalation layer 04 includes at least one first intercalation sublayer 04a and at least one second intercalation sublayer 04b, and the first intercalation sublayer 04a and the second intercalation sublayer 04b are alternately disposed in the direction, for example, the direction Z, from the first electrode 01 to the second electrode 02.

A thickness of the first intercalation sublayer 04a may be the same as or different from a thickness of the second intercalation sublayer 04b. The figure shows a case in which the thickness of the first intercalation sublayer 04a is the same as the thickness of the second intercalation sublayer 04b. A quantity of first intercalation sublayers 04a may be the same as or different from a quantity of second intercalation sublayers 04b. The figure shows a case in which the quantity of first intercalation sublayers 04a is the same as the quantity of second intercalation sublayers 04b, that is, the first intercalation sublayers 04a and the second intercalation sublayers 04b are disposed in pairs.

Refer to FIG. 11. For example, the intercalation layer 04 includes one first intercalation sublayer 04a and one second intercalation sublayer 04b, and the first intercalation sublayer 04a and the second intercalation sublayer 04b are stacked.

Refer to FIG. 12. For example, the intercalation layer 04 includes a plurality of first intercalation sublayers 04a and a plurality of second intercalation sublayers 04b, and the first intercalation sublayers 04a and the second intercalation sublayers 04b are alternately stacked.

In addition, a dielectric constant of a material of the first intercalation sublayer 04a is different from a dielectric constant of a material of the second intercalation sublayer 04b, a dielectric constant of a material on a surface on which the first intercalation sublayer 04a is in contact with the second intercalation sublayer 04b changes, and the first intercalation sublayer 04a and the second intercalation sublayer 04b are stacked in a superlattice manner, so that in the direction Z, two opposite surfaces of the first intercalation sublayer 04a generate electric dipoles, and two opposite surfaces of the second intercalation sublayer 04b generate electric dipoles.

The first intercalation sublayers 04a and the second intercalation sublayers 04b are alternately disposed. On the surface on which the first intercalation sublayer 04a is in contact with the second intercalation sublayer 04b, a positive charge and a negative charge attract each other, and charges distributed on a surface that is of the first intercalation sublayer 04a and that is away from the second intercalation sublayer 04b and charges distributed on a surface that is of the second intercalation sublayer 04b and that is away from the first intercalation sublayer 04a are opposite in signs: positive and negative, and may be combined to form "long-range" electric dipoles.

From an overall perspective of the stacked structure of the intercalation layer 04, charges distributed on a top surface of a top intercalation sublayer in the stacked structure and charges distributed on a bottom surface of a bottom intercalation sublayer in the stacked structure are opposite in signs: positive and negative, and may be combined to form "long-range" electric dipoles, so that the electric dipoles are generated on the top surface and the bottom surface of the intercalation layer 04. Therefore, a potential difference is generated between the two opposite ends of the intercalation layer 04.

For example, the material of the first intercalation sublayer 04a may include titanium oxide, and the material of the second intercalation sublayer 04b may include niobium oxide. Dielectric constants of titanium oxide and niobium oxide are different, so that the first intercalation sublayer 04a and the second intercalation sublayer 04b are stacked in the superlattice manner. Therefore, electric dipoles are generated on two opposite surfaces of the first intercalation sublayer 04a, and electric dipoles are generated on two opposite surfaces of the second intercalation sublayer 04b.

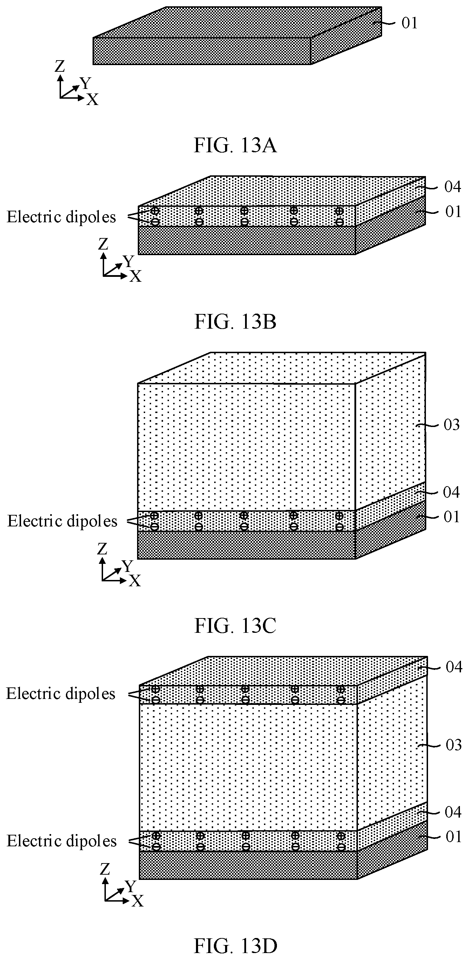

An embodiment of this application provides a method for preparing the ferroelectric capacitor C shown in FIG. 8. FIG. 13A to FIG. 13E are diagrams of steps of preparing a ferroelectric capacitor according to an embodiment of this application.

Refer to FIG. 13A. The first electrode 01 is formed.

For example, a chemical vapor deposition (Chemical Vapor Deposition, CVD) process may be used to deposit a metal material on a substrate (silicon wafer), to form the first electrode 01. The metal material may include, for example, tungsten, and a thickness of the first electrode 01 may be 50 nm.

Because the first electrode 01 is located on the substrate and is located at a bottom of the ferroelectric capacitor C, the first electrode 01 may also be referred to as a "bottom electrode".

Refer to FIG. 13B. The intercalation layer 04 is formed. The intercalation layer 04 includes electric dipoles, and the electric dipoles may generate an electric field. Therefore, in the direction Z, there is a potential difference between two opposite ends of the intercalation layer 04.

For example, a physical vapor deposition (Physical Vapor Deposition, PVD) process may be used to deposit a strontium titanate material above the first electrode 01, and at the same time, the strontium titanate material is doped with a niobium element, to change intrinsic parameters of the strontium titanate material. Therefore, a defect with a high concentration and a low energy level is introduced into the material, to generate the electric dipoles at the intercalation layer 04. A thickness of the intercalation layer 04 may be 2 nm.

Refer to FIG. 13C. The ferroelectric layer 03 is formed.

For example, an atomic layer deposition (Atomic Layer Deposition, ALD) process may be used to deposit a hafnium element and a zirconium element at the intercalation layer 04, and a mass ratio of the hafnium element to the zirconium element is 1:1, to form the ferroelectric layer 03 including hafnium zirconium oxide (chemical formula: Hf_{0.5}Zr_{0.5}O₂) at the intercalation layer 04. A thickness of the ferroelectric layer 03 may be 10 nm.

In a process of forming the ferroelectric layer 03, a material of the ferroelectric layer 03 may crystallize, a polarization axis of the material may be arranged in an electric field direction of the electric dipoles under guidance of the electric field generated by the electric dipoles, to help improve a spontaneous polarization characteristic of the material.

Refer to FIG. 13D. The intercalation layer 04 may be formed at the ferroelectric layer 03 by using a same method.

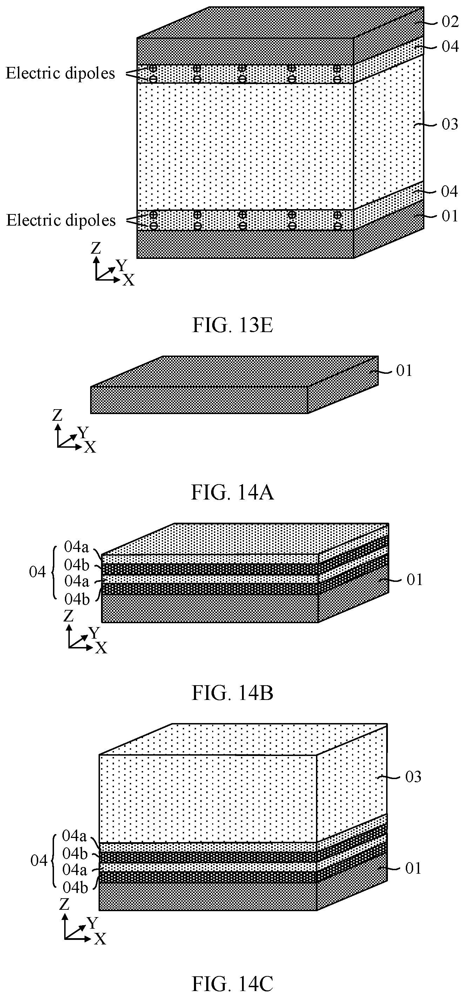

Refer to FIG. 13E. The second electrode 02 is formed.

For example, the chemical vapor deposition process may be used to deposit tungsten on the substrate, to form the second electrode 02.

Alternatively, the physical vapor deposition process may be used to deposit a titanium nitride material on the substrate, to form the second electrode 02.

A thickness of the second electrode 02 may be 50 nm. Because the second electrode 02 is located at a top of the ferroelectric capacitor C, the second electrode 02 may also be referred to as a "top electrode".

Still refer to FIG. 13E. After the structure in the figure is formed, rapid thermal annealing is performed on the structure, so that a material of the ferroelectric layer 03 crystallizes to form a ferroelectric phase crystal. In this process, the electric field generated by the electric dipoles may also guide the polarization axis of the material to be arranged in the electric field direction.

According to the preparation method provided in the foregoing embodiments of this application, the first electrode 01, the ferroelectric layer 03, and the second electrode 02 are sequentially formed, and the intercalation layer 04 is formed between the first electrode 01 and the ferroelectric layer 03, and the intercalation layer 04 is formed between the ferroelectric layer 03 and the second electrode 02.

The intercalation layer 04 is doped with the element, to change the intrinsic parameters of the material. Therefore, a defect with a high concentration and a low energy level is introduced into the material, to generate the electric dipoles at the intercalation layer 04. The electric dipoles may generate the electric field. In a process in which the ferroelectric material of the ferroelectric layer 03 crystallizes, the polarization axis of the ferroelectric material may be arranged in the electric field direction under guidance of the electric field generated by the electric dipoles, to help improve a spontaneous polarization characteristic of the ferroelectric material.

An embodiment of this application further provides a method for preparing the ferroelectric capacitor C shown in FIG. 12. FIG. 14A to FIG. 14E are diagrams of steps of preparing a ferroelectric capacitor according to an embodiment of this application.

Refer to FIG. 14A. The first electrode 01 is formed. A preparation method is the same as that described above.

Refer to FIG. 14B. The intercalation layer 04 is formed. The intercalation layer 04 includes electric dipoles, and the electric dipoles may generate an electric field. Therefore, in the direction Z, there is a potential difference between two opposite ends of the intercalation layer 04.

For example, an atomic layer deposition process may be used to deposit a niobium oxide material on the first electrode 01, to form the second intercalation sublayer 04b. Then, the atomic layer deposition process is used to deposit a titanium oxide material on the second intercalation sublayer 04b, to form the first intercalation sublayer 04a. In this way, second intercalation sublayers 04b and first intercalation sublayers 04a are alternately formed, and the second intercalation sublayers 04b and the first intercalation sublayers 04a are stacked to form the intercalation layer 04. A thickness of the intercalation layer 04 may be 2 nm.

Alternatively, the first intercalation sublayer 04a may be formed on the first electrode 01, and then the second intercalation sublayer 04b may be formed on the first intercalation sublayer 04a. In this way, first intercalation sublayers 04a and second intercalation sublayers 04b are alternately formed. This is not limited in this embodiment of this application.

Dielectric constants of titanium oxide and niobium oxide are different, so that the second intercalation sublayer 04b and the first intercalation sublayer 04a are stacked in a superlattice manner. Therefore, electric dipoles are generated on two opposite surfaces of the first intercalation sublayer 04a, and electric dipoles are generated on two opposite surfaces of the second intercalation sublayer 04b.

Refer to FIG. 14C. The ferroelectric layer 03 is formed. A preparation method is the same as that described above. Similarly, in a process of forming the ferroelectric layer 03, a material of the ferroelectric layer 03 may crystallize, a polarization axis of the material may be arranged in an electric field direction of the electric dipoles under guidance of the electric field generated by the electric dipoles, to help improve a spontaneous polarization characteristic of the material.

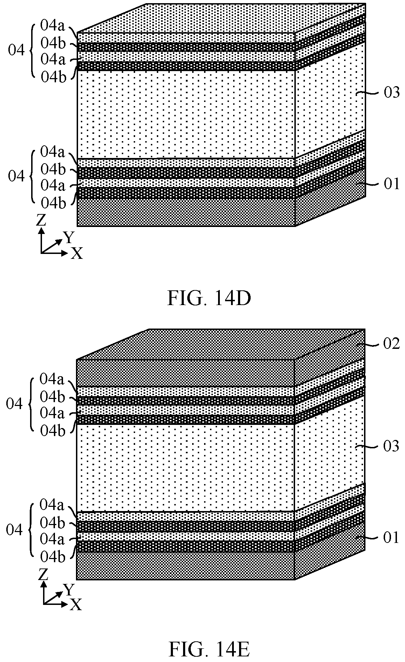

Refer to FIG. 14D. A same method may be used to alternately form the second intercalation sublayers 04b and the first intercalation sublayers 04a at the ferroelectric layer 03, to form the intercalation layer 04.

Refer to FIG. 14E. The second electrode 02 is formed. A preparation method is the same as that described above.

Still refer to FIG. 14E. After the structure in the figure is formed, rapid thermal annealing is also performed on the structure, so that the material of the ferroelectric layer 03 crystallizes to form a ferroelectric phase crystal. In this process, the electric field generated by the electric dipoles may also guide the polarization axis of the material to be arranged in the electric field direction.

According to the preparation method provided in the foregoing embodiments of this application, the first electrode 01, the ferroelectric layer 03, and the second electrode 02 are sequentially formed, and the intercalation layer 04 is formed between the first electrode 01 and the ferroelectric layer 03, and the intercalation layer 04 is formed between the ferroelectric layer 03 and the second electrode 02.

The second intercalation sublayers 04b and the first intercalation sublayers 04a are alternately formed, and the second intercalation sublayers 04b and the first intercalation sublayers 04a are stacked to form the intercalation layer 04. A dielectric constant of a material of the first intercalation sublayer 04a is different from a dielectric constant of a material of the second intercalation sublayer 04b, a dielectric constant of a surface on which the first intercalation sublayer 04a is in contact with the second intercalation sublayer 04b changes, so that two opposite surfaces of the first intercalation sublayer 04a generate electric dipoles, and two opposite surfaces of the second intercalation sublayer 04b generate electric dipoles. The electric dipoles may generate the electric field. In a process in which the ferroelectric material of the ferroelectric layer 03 crystallizes, the polarization axis of the ferroelectric material may be arranged in the electric field direction under guidance of the electric field generated by the electric dipoles, to help improve a spontaneous polarization characteristic of the ferroelectric material.

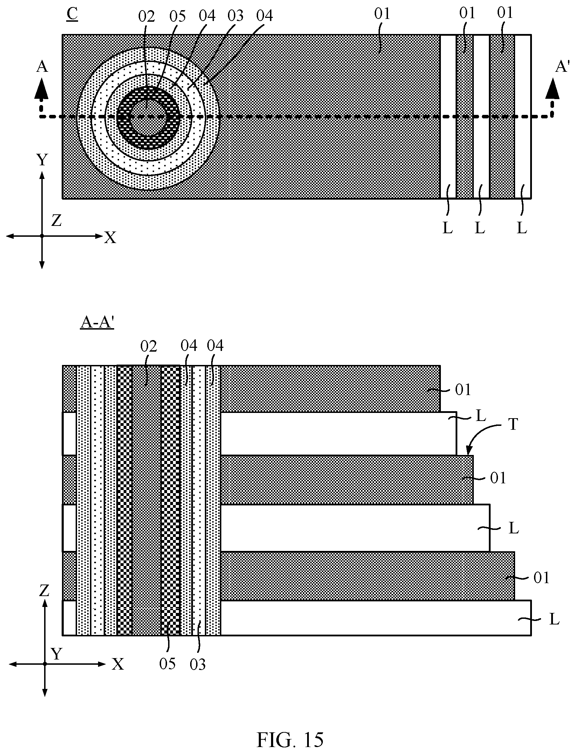

A structure of the ferroelectric capacitor C provided in this embodiment of this application may alternatively be a three-dimensional vertical structure. FIG. 15 is a diagram of a three-dimensional structure of a ferroelectric capacitor according to an embodiment of this application.

Refer to FIG. 15. The first electrode 01 of the ferroelectric capacitor C is a planar electrode, the second electrode 02 is a columnar electrode, first electrodes 01 and dielectric layers L alternately form a stacked structure, the plurality of first electrodes 01 form stepped surfaces T, and the first electrode 01 is connected to the outside through the stepped surface T. The second electrode 02 penetrates the first electrodes 01 and the dielectric layers L in the stacked structure, a side surface of the second electrode 02 is opposite to the first electrode 01, and the ferroelectric layer 03 and the intercalation layers 04 are disposed around the side surface of the second electrode 02, to separate the first electrode 01 from the second electrode 02.

For example, the intercalation layers 04 are disposed between the ferroelectric layer 03 and the first electrode 01 and between the ferroelectric layer 03 and the second electrode 02. Each intercalation layer 04 may be the single-layer film layer or the composite film layer described above.

For example, materials of the first electrode 01 and the second electrode 02 each include tungsten. The ferroelectric capacitor C further includes a third electrode 05, a material of the third electrode 05 includes titanium nitride, the third electrode 05 may be located between the second electrode 02 and the intercalation layer 04, and the third electrode 05 and the second electrode 02 form a composite electrode.

The ferroelectric capacitor C uses the foregoing three-dimensional vertical structure design, to reduce an area occupied by the ferroelectric capacitor C on an X-Y plane. This can increase a quantity of ferroelectric capacitors C disposed per unit area on the X-Y plane, to increase a quantity of memory cells 200 disposed per unit area, and help improve storage density of the ferroelectric memory.

Based on a 1T1C structure of the memory cell 200, the memory cell 200 includes one ferroelectric capacitor C and one transistor T. The first electrode 01 of the ferroelectric capacitor C is a planar electrode, and the second electrode 02 is a columnar electrode. In this case, the second electrode 02 is electrically connected to the transistor T through a contact pillar, that is, the columnar electrode of the ferroelectric capacitor C is electrically connected to the transistor T, to form the memory cell 200.

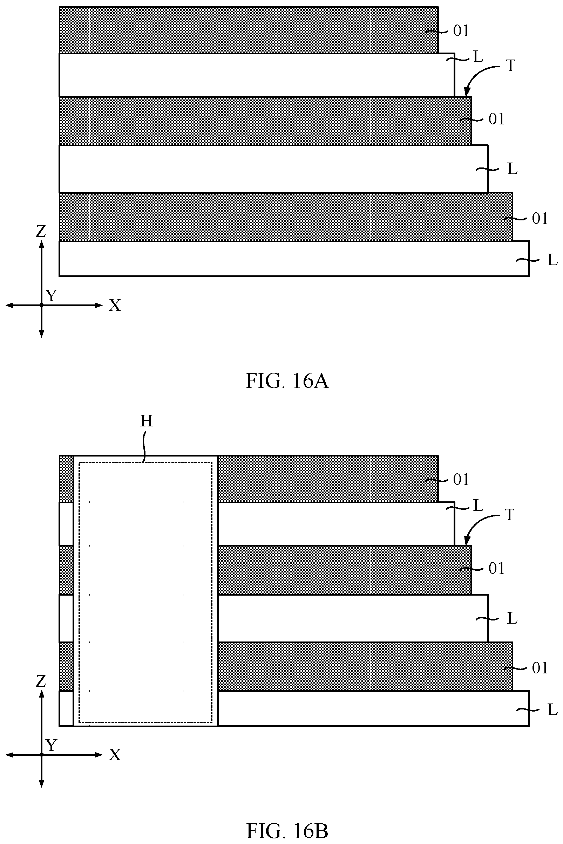

An embodiment of this application further provides a method for preparing the ferroelectric capacitor C shown in FIG. 15. FIG. 16A to FIG. 16G are diagrams of steps of preparing a ferroelectric capacitor according to an embodiment of this application.

Refer to FIG. 16A. The dielectric layers L and the first electrodes 01 are alternately formed. A total thickness of the dielectric layers L and the first electrodes 01 may be 100 nm. The dielectric layer L may separate two adjacent first electrodes 01, so that the two adjacent first electrodes 01 are insulated.

For example, an etching process may be used to etch the dielectric layers L and the first electrodes 01, so that the plurality of first electrodes 01 form the stepped surfaces T.

Refer to FIG. 16B. A hole H that penetrates the first electrodes 01 and the dielectric layers L is formed.

For example, the etching process may be used to etch the first electrodes 01 and the dielectric layers L, to form the hole H that penetrates the first electrodes 01 and the dielectric layers L. A diameter of the hole H may be 50 nm.

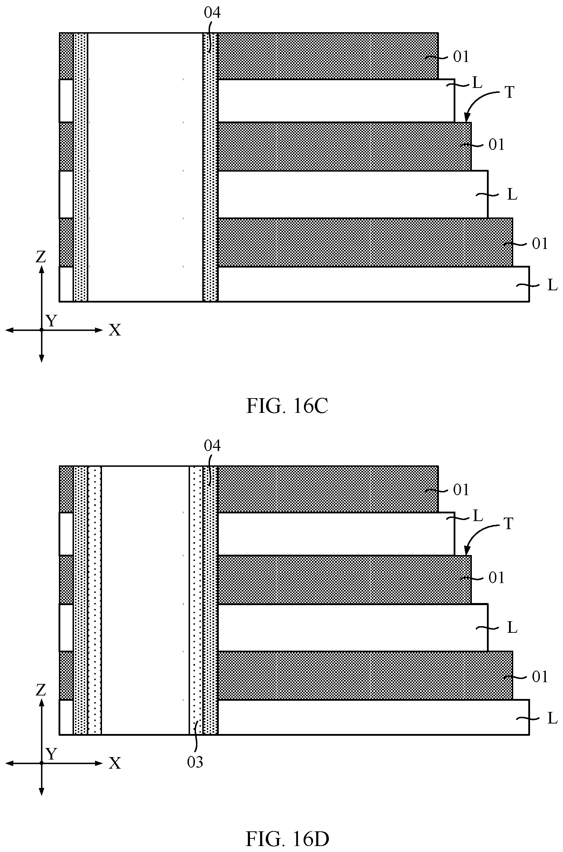

Refer to FIG. 16B and FIG. 16C. The intercalation layer 04 is formed on a side wall of the hole H.

For example, the intercalation layer 04 is a single film layer. A tantalum oxide material may be deposited on the side wall of the hole H, and at the same time, the tantalum oxide material is doped with a niobium element, to change intrinsic parameters of the tantalum oxide material. Therefore, a defect with a high concentration and a low energy level is introduced into the material, to generate electric dipoles at the intercalation layer 04. A thickness of the intercalation layer 04 may be 2 nm.

The intercalation layer 04 may alternatively be a composite film layer. A preparation method of the intercalation layer 04 is the same as that described above.

Refer to FIG. 16D. The ferroelectric layer 03 is formed on an inner side of the intercalation layer 04. A preparation method is the same as that described above. For example, a thickness of the ferroelectric layer 03 may be 10 nm.

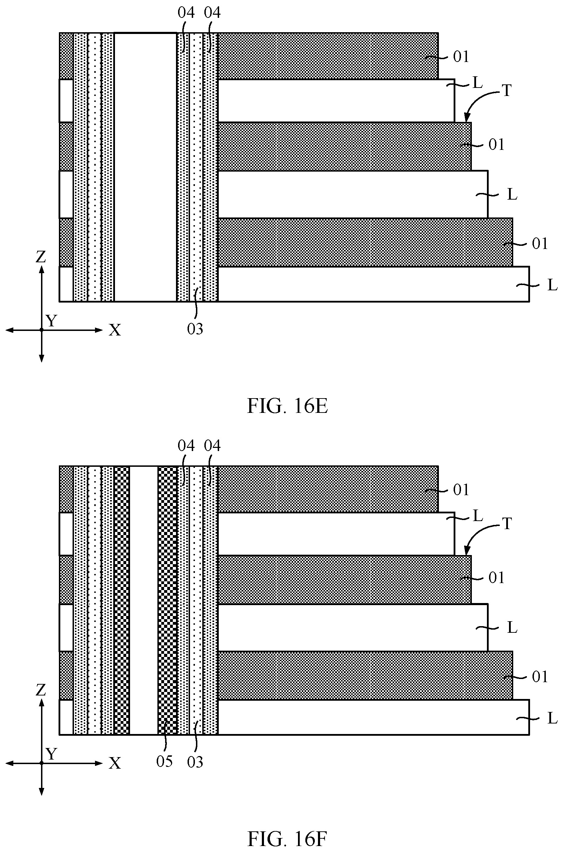

Refer to FIG. 16E. The intercalation layer 04 is formed on an inner side of the ferroelectric layer 03. A preparation method is the same as that described above. For example, a thickness of the intercalation layer 04 may be 2 nm.

Refer to FIG. 16F. The third electrode 05 is formed on an inner side of the intercalation layer 04.

For example, a titanium nitride material may be deposited on the inner side of the intercalation layer 04, to form the third electrode 05. A thickness of the third electrode 05 may be 5 nm.

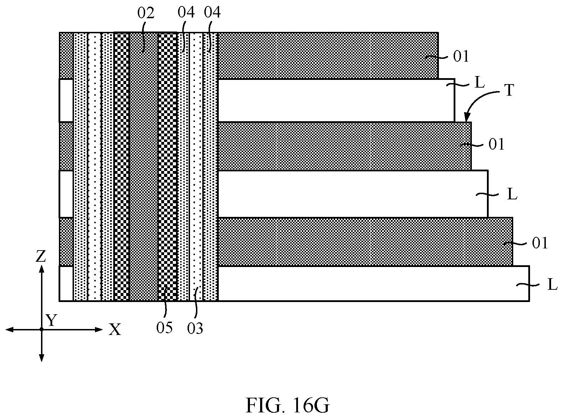

Refer to FIG. 16G. The second electrode 02 is formed on an inner side of the third electrode 05.

According to the preparation method provided in the foregoing embodiments of this application, the first electrodes 01 are formed, then the hole H that penetrates the first electrodes 01 is formed, and the ferroelectric layer 03 and the intercalation layers 04 are formed on the side wall of the hole H. Finally, the second electrode 02 is formed on the inner side of the ferroelectric layer 03, and the second electrode 02 penetrates the first electrodes 01, to form the three-dimensional ferroelectric capacitor C.

In addition, the intercalation layer 04 in the ferroelectric capacitor C provided in embodiments of this application may be further used in various three-dimensional vertical opening structures, for example, a 3D DRAM, a 3D RRAM, a 3D PCRAM, a 3D FeRAM, and a 3D NAND, and may also be used in a field effect transistor with a vertical channel.

The foregoing descriptions are merely specific implementations of the present invention, and are not intended to limit the protection scope of the present invention. Any variation or replacement readily figured out by a person skilled in the art within the technical scope disclosed in the present invention shall fall within the protection scope of the present invention. Therefore, the protection scope of the present invention shall be subject to the protection scope of the claims.

## Claims

1. A ferroelectric memory array, comprising a plurality of memory cells arranged in an array, wherein the memory cell comprises a ferroelectric capacitor and a transistor; and
the ferroelectric capacitor comprises:
a first electrode and a second electrode that are disposed opposite to each other;
a ferroelectric layer, disposed between the first electrode and the second electrode; and
at least one intercalation layer, disposed between the ferroelectric layer and the first electrode, and/or between the ferroelectric layer and the second electrode, wherein
when the first electrode and the second electrode do not receive a voltage signal, the intercalation layer comprises electric dipoles, and the electric dipoles are distributed on two opposite surfaces of the intercalation layer in a direction from the first electrode to the second electrode.

2. The ferroelectric memory array according to claim 1, wherein the intercalation layer comprises at least one first intercalation sublayer and at least one second intercalation sublayer;
the first intercalation sublayer and the second intercalation sublayer are alternately disposed in the direction from the first electrode to the second electrode; and
a dielectric constant of a material of the first intercalation sublayer is different from a dielectric constant of a material of the second intercalation sublayer.

3. The ferroelectric memory array according to claim 1 or 2, wherein the intercalation layer is doped with an element, and the element comprises at least one of niobium, titanium, hafnium, zirconium, lanthanum, yttrium, strontium, silicon, germanium, tantalum, or tungsten.

4. The ferroelectric memory array according to any one of claims 1 to 3, wherein a material of the intercalation layer comprises a piezoelectric material.

5. The ferroelectric memory array according to any one of claims 1 to 4, wherein the material of the intercalation layer comprises a pyroelectric material.

6. The ferroelectric memory array according to any one of claims 1 to 5, wherein the material of the intercalation layer comprises a ferroelectric material.

7. The ferroelectric memory array according to any one of claims 1 to 6, wherein the material of the intercalation layer comprises at least one of titanium oxide, niobium oxide, tantalum oxide, yttrium oxide, lanthanum oxide, barium oxide, cerium oxide, gadolinium oxide, aluminum oxide, hafnium oxide, zirconium oxide, silicon nitride, titanium nitride, niobium nitride, tantalum nitride, hafnium nitride, zirconium nitride, strontium titanate, barium titanate, lanthanum aluminate, lithium niobate, or lithium tantalate.

8. The ferroelectric memory array according to any one of claims 1 to 7, wherein a thickness of the intercalation layer ranges from 0.5 nm to 5 nm.

9. The ferroelectric memory array according to any one of claims 1 to 8, wherein both the first electrode and the second electrode are planar electrodes, and the first electrode, the ferroelectric layer, the intercalation layer, and the second electrode are stacked.

10. The ferroelectric memory array according to any one of claims 1 to 8, wherein the first electrode is a planar electrode, and the second electrode is a columnar electrode; and
the second electrode penetrates the first electrode, and both the ferroelectric layer and the intercalation layer are disposed around the second electrode.

11. The ferroelectric memory array according to any one of claims 1 to 10, wherein a thermal expansion coefficient of a material of the first electrode is different from a thermal expansion coefficient of a material of the second electrode.

12. A preparation method for preparing a ferroelectric memory array, comprising:
sequentially forming a first electrode, a ferroelectric layer, and a second electrode, wherein the first electrode and the second electrode are disposed opposite to each other, and the ferroelectric layer is located between the first electrode and the second electrode, wherein
after the first electrode is formed and before the ferroelectric layer is formed, an intercalation layer is further formed; and/or after the ferroelectric layer is formed and before the second electrode is formed, the intercalation layer is further formed; and
the intercalation layer comprises electric dipoles, and the electric dipoles are distributed on two opposite surfaces of the intercalation layer in a direction from the first electrode to the second electrode.

13. A memory, comprising:
the ferroelectric memory array according to any one of claims 1 to 11, and
a controller, electrically connected to the ferroelectric memory array.

14. An electronic device, comprising:
a circuit board, and
the memory according to claim 13, electrically connected to the circuit board.
